# EUROPÄISCHE PATENTSCHRIFT

(11) **EP 2 639 828 B1**
(45) Veröffentlichungstag und Bekanntmachung des Hinweises auf die Patenterteilung: **07.07.2021**
(21) Anmeldenummer: 13157536.7
(22) Anmeldetag: 04.03.2013
(51) Int. Cl.: H01L 25/07, H01L 21/48, H01L 23/495

(54) **SCHALTUNGSTRÄGERANORDNUNG**
ASSEMBLY OF CIRCUIT SUPPORTS
AGENCEMENT DE SUPPORTS DE CIRCUIT

(30) Priorität: 14.03.2012 DE 102012204006
(43) Veröffentlichungstag der Anmeldung: 18.09.2013
(73) Patentinhaber: Robert Bosch GmbH, 70442 Stuttgart (DE)
(72) Erfinder: Rapp, Manuela, 70794 Filderstadt-Sielmingen (DE); Sueske, Erik, 72764 Reutlingen (DE); Michels, Daniel, 72768 Reutlingen (DE); Geinitz, Eckart, 72793 Pfullingen (DE); Klett, Gustav, 72116 Moessingen (DE); Braun, Gerhard, 72108 Rottenburg (DE)

(56) Entgegenhaltungen:
- DE-A1-102004 031 592
- DE-A1-102007 003 875
- US-A1- 2002 167 075
- US-A1- 2009 284 927
- None

## Beschreibung

### Stand der Technik

Die Erfindung betrifft eine Schaltungsträgeranordnung mit wenigstens einem elektronischen Bauelement, insbesondere einem Halbleiterbauelement. Die Schaltungsträgeranordnung weist wenigstens zwei Schaltungsträger auf. Bevorzugt erstrecken sich die Schaltungsträger wenigstens abschnittsweise parallel zueinander und schließen das Bauelement wenigstens teilweise oder vollständig zwischeneinander ein. Das elektronische Bauelement ist mit wenigstens einem Schaltungsträger, bevorzugt mit zwei Schaltungsträgern stoffschlüssig, bevorzugt mittels Löten oder Schweissen, elektrisch leitfähig verbunden.

Bei aus dem Stand der Technik bekannten Halbleiterbauelementen, insbesondere Leistungshalbleiterschaltern, welche mit Schaltungsträgern niederohmig und elektrisch leitfähig verbunden sind, wobei der Leistungshalbleiterschalter nach Art eines Sandwichs zwischen den Schaltungsträgern eingeschlossen ist, kann ein Abstand der Schaltungsträger vor einem Verlöten in einem Lötofen mittels eines überstehenden Bereiches des oberen Schaltungsträgers eingestellt werden, welcher auf einem Rahmen eines Werkstückträgers aufliegt. Die Schaltungsträgeranordnung mit den zwei zueinander parallel verlaufenden Schaltungsträgern, welche das Leistungshalbleiterbauelement zwischeneinander einschließen, liegt dann in einer Senke des Werkstückträgers. Der Werkstückträger kann so bemessen sein, dass bei einem Absenken des oberen Schaltungsträgers beim Verlöten im Lötofen, bewirkt durch das Schmelzen des Lotes zwischen dem Schaltungsträger und dem Leistungshalbleiter, der Abstand zwischen den Schaltungsträgern und somit die Stärke der Lotschicht mittels des Werkstückträgers eingestellt werden kann. Die Stärke der Lotschicht ist bei diesem Verfahren von Fertigungstoleranzen der Schaltungsträger, insbesondere einer Dickentoleranz der Schaltungsträger abhängig.

Aus Offenlegungsschrift DE 10 2004 031 592 A1 ist ein aus Photolack gebildeter Abstandshalter oder ein gefräster oder gestanzter Abstandshalter als Strukturierung eines Substrats oder einer Substratschicht bekannt.

Die Offenlegungsschrift DE 10 2007 003 875 A1 offenbart eine Stromschienenanordnung, bei der Stromschienen mittels eines keramischen Wärmeleitelements mit einer Wärmesenke verbunden sind. Das Wärmeleitelement erstreckt sich dabei quer zur Stromschiene.

### Offenbarung der Erfindung

Erfindungsgemäß weist der Schaltungsträgeranordnung nach Anspruch 1 wenigstens zwei Schaltungsträger auf. Die Schaltungsträgeranordnung weist wenigstens einen elektrisch isolierenden Abstandshalter auf, wobei der Abstandshalter mit einem Schaltungsträger verbunden ist und sich quer zum Schaltungsträger bis zu dem anderen Schaltungsträger hin erstreckt. Dabei ist der Abstandshalter in einer Aussparung oder einem Durchbruch des Schaltungsträgers gehalten. Der Abstandshalter kann dazu beispielsweise in einen zylinderförmigen Durchbruch mit einem Endabschnitt eingeführt werden. Nach dem Einführen des Endabschnitts wird der Schaltungsträger im Bereich des Durchbruchs verpresst. Der Schaltungsträger, insbesondere ein Rand des Schaltungsträgers im Bereich des Durchbruchs, wird dadurch im Bereich des Abstandshalters plastisch radial in den Durchbruch hinein verformt, sodass der Abstandshalter in dem Durchbruch gehalten ist.

So ist die Einstellung des Abstandes zwischen den Schaltungsträgern vorteilhaft nicht mehr von einer Dickentoleranz der Schaltungsträger oder des Werkstückträgers, und weiter vorteilhaft auch nicht von eventuellen Verschmutzungen des Werkstückträgers, in der die Schaltungsträgeranordnung vor dem Verlöten liegt, abhängig.

Der Schaltungsträger ist bevorzugt durch ein bevorzugt gestanztes Blech, insbesondere Kupferblech gebildet. Der Schaltungsträger ist in einer anderen Ausführungsform durch eine Leiterplatte, insbesondere eine faserverstärkte Leiterplatte, ein IMS (IMS = Insulated-Metal-Substrate) oder einen keramischer Schaltungsträger gebildet.

In einer bevorzugten Ausführungsform weist der Abstandshalter Kunststoff auf, weiter bevorzugt weist der Abstandshalter einen Kunststoff auf, oder ist aus Kunststoff, gebildet. Der Kunststoff ist bevorzugt ein Duroplast.

Bevorzugt weist der Abstandshalter neben dem Kunststoff einen Füllstoff, insbesondere einen anorganischen Füllstoff auf.

Der Füllstoff ist bevorzugt durch Füllpartikel gebildet.

Die Füllpartikel sind beispielsweise Fasern, Kugeln, oder zueinander unregelmäßig geformte Bruchstücke des Füllmaterials gebildet. Das Füllmaterial ist beispielsweise Glas, Keramik oder Carbon. Im Falle der Glasfaser wird vorteilhaft eine hohe mechanische Festigkeit erreicht, im Falle der Glaskugeln kann keine Feuchtigkeit entlang des Füllstoffs in den Abstandshalter diffundieren.

Weiter vorteilhaft wird ein thermischer Ausdehnungskoeffizient des Verbundmaterials, umfassend den Kunststoff und den Füllstoff gering gehalten.

Beispielhafte weitere Ausführungsformen für den Kunststoff sind Polyether, Polyester, Polyamid, Polyimid, Phenolharz, Epoxidharz, Silikon, oder ein wärmebeständiges Thermoplast, beispielsweise PTFE (PTFE = Polytetrafluorethylen), PPS (PPS = Polyphenylensulfid), LCP (LCP = Liquid-Chrystal-Polymer), PEEK (PEEK = Polyether-ether-ketone), , PAI (PAI = Polyamidimid), PBI (PBI = Polybenzimidazol),.

Im Falle des Abstandshalters aus dem Thermoplast kann der Abstandshalter vorteilhaft an den Schaltungsträger angespritzt werden.

In einer bevorzugten Ausführungsform weist der Abstandshalter Keramik auf, weiter bevorzugt ist der Abstandshalter aus Keramik gebildet. Die Keramik weist bevorzugt Aluminiumoxid, Zirkoniumoxid oder Siliziumnitrid auf. In einer anderen Ausführungsform ist der Abstandshalter aus Glas gebildet oder weist Glas auf. Durch den Abstandshalter aus Keramik kann der Abstandshalter vorteilhaft beim Löten im Lötofen formstabil bleiben. Beim Verlöten im Lötofen herrscht beispielsweise eine Löttemperatur zwischen 250 bis 300 Grad Celsius.

Abweichend von der erfindungsgemäßen Ausführung kann der Schaltungsträger im Bereich eines Randes des Durchbruchs wenigstens einen Vorsprungsbereich aufweisen, welcher sich vom Rand des Durchbruchs - bevorzugt nur auf einem Teil der Durchbruchtiefe - radial nach innen erstreckt. Der Abstandshalter kann zum Verbinden mit dem Schaltungsträger in den Durchbruch eingeschoben werden, bis das Ende des Abstandshalters gegen den Vorsprungsbereich stößt. Beim Weiterschieben, beispielsweise Einpressen des Abstandshalters ist der Abstandshalter durch die Durchbruchwandung bis hin zum Vorsprungsbereich geführt und kann den Vorsprungsbereich plastisch verformen, oder zusätzlich selbst durch den Vorsprungsbereich beim weiteren Einschieben plastisch verformt werden. Auf diese Weise kann eine Pressung erzeugt werden, sodass der Abstandshalter in dem Durchbruch des Schaltungsträgers gehalten ist.

Abweichend von der erfindungsgemäßen Ausführung ist in einer anderen Ausführung der Abstandshalter ausgebildet, auf eine Kante des Schaltungsträgers aufgeschoben zu werden und dort am Schaltungsträger festzuhalten. Der Abstandshalter kann dazu ein Klemmelement aufweisen, welches ausgebildet ist, den Rand des Schaltungsträgers wenigstens teilweise zu umgreifen und so den Abstandshalter mit dem Schaltungsträger unlösbar einander zu verbinden. Bevorzugt weist das Klemmelement wenigstens einen Widerhaken auf, welcher ausgebildet und angeordnet ist, in eine Oberfläche des Schaltungsträgers einzugreifen.

Die Erfindung betrifft auch ein Verfahren nach Anspruch 12. Bei diesem Verfahren handelt es sich um ein Verfahren zum elektrischen Verbinden wenigstens eines elektronischen Bauelements, insbesondere Halbleiterbauelement, mit wenigstens zwei Schaltungsträgern, bei dem zwei Schaltungsträger jeweils über ein Lotmittel mit dem Bauelement in berührenden Kontakt gebracht werden, so dass die Schaltungsträger das Bauelement zwischeneinander einschließen, wobei zwischen den Schaltungsträgern wenigstens ein insbesondere im Bereich des Bauelements angeordneter, mit einem Schaltungsträger verbundener Abstandshalter angeordnet ist. Bei einem anschließenden Verlöten der Schaltungsträger mit dem Halbleiterbauelement in einem Lötofen werden die Schaltungsträger beim Schmelzen des Lotmittels - insbesondere mittels Schwerkraft - aufeinander zu bewegt, bis der Abstandshalter zwischen den Schaltungsträgern das Bewegen stoppt, so dass das Lotmittel zwischen dem Bauelement und dem Schaltungsträger eine vorbestimmte Dicke aufweist.

Mittels des Abstandshalters kann so vorteilhaft ein vorbestimmter Abstand zwischen den Schaltungsträgern genau eingestellt werden.

Das Halbleiterbauelement ist bevorzugt eine Halbleiterdiode, ein Halbleiterschalter, insbesondere ein Feldeffekttransistor, ein IGBT (IGBT= Insulated-Gate-Bipolar-Transistor) oder ein Thyristor.

Anders als die Erfindung kann der Abstandshalter an den Schaltungsträger beispielsweise angeformt oder angeklebt werden. Ein Klebstoff zum Ankleben des Abstandshalters ist beispielsweise Epoxidharz. Das Epoxidharz ist bevorzugt derart wärmebeständig ausgebildet, dass es beim Verlöten im Lötofen nicht zersetzt werden kann.

Grundsätzlich wird der Abstandshalter jedoch mit einem Endabschnitt in dem Durchbruch des Schaltungsträgers eingefügt. Der Abstandshalter kann so mit dem Schaltungsträger fest verbunden werden. Die feste Verbindung zwischen dem Abstandshalter und dem Schaltungsträger gewährleistet vorteilhaft darüber hinaus das Wegfallen einer Toleranzfehlerquelle im Vergleich zu einem Abstandshalter, der vor einem Verlöten zwischen die Schaltungsträger - beispielsweise im Bereich eines Randes - eingefügt wird, und nach einem Verlöten wieder mechanisch entfernt wird. Bei dem mechanischen Entfernen kann die Lötverbindung mechanisch belastet werden, was zu einem Brechen der Lötverbindung oder einer Beschädigung der Lötverbindung führen kann.

Der Schaltungsträger wird ferner im Bereich des Durchbruchs verpresst, sodass der Abstandshalter in dem Durchbruch kraftschlüssig oder kraftschlüssig und zusätzlich formschlüssig gehalten ist.

Bevorzugt wird bei dem Verfahren der Abstandshalter nach dem Verlöten mittels eines Laserstrahls wenigstens teilweise oder vollständig entfernt, insbesondere weggebrannt und/oder wegverdampft. Dadurch kann der Abstandshalter nur während des Verlötens zum Einstellen des Abstands zwischen den Schaltungsträgern dienen, während eines Betriebes einer Schaltungsanordnung mit der Schaltungsträgeranordnung kann der Abstandshalter bei thermischen Ausdehnungen von Teilen der Schaltungsträgeranordnung die Lötverbindungen zwischen dem Schaltungsträger und dem elektronischen Bauelement, insbesondere dem Halbleiterbauelement, nicht beeinträchtigen.

Mittels des Laserstrahls kann der Abstandshalter vorteilhaft an schwer zugänglichen Stellen weggebrannt werden. Weiter vorteilhaft kann der Abstand zwischen den Schaltungsträgern an nur wenigen Punkten sicher eingestellt werden, ohne einen größeren, beispielsweise durch eine Schablone gebildeten Abstandshalter zu verwenden, der dann anschließend mechanisch wieder aus dem Zwischenraum zwischen den Schaltungsträgern entfernt wird.

In einer bevorzugten Ausführungsform des Verfahrens wird der Laserstrahl durch den Durchbruch hindurch gesendet und entfernt so den Abstandshalter wenigstens teilweise oder vollständig. Der Laserstrahl kann so bevorzugt senkrecht auf eine Schaltungsträgerebene des Schaltungsträgers treffen und durch den Durchbruch hindurch den im Durchbruch angeordneten Abstandshalter entfernen, insbesondere wegschmelzen oder wegbrennen. Die Schaltungsträgeranordnung, insbesondere die Lötstellen der Schaltungsträgeranordnung zwischen den Schaltungsträgern und den elektronischen Bauelementen, bevorzugt Halbleiterbauelementen, wird so vorteilhaft nicht durch das Entfernen des wenigstens einen Abstandshalters mechanisch belastet.

Die Erfindung wird nun im Folgenden anhand von Figuren und weiteren Ausführungsbeispielen beschrieben. Weitere vorteilhafte Ausführungsvarianten ergeben sich aus den in den Figuren und in den abhängigen Ansprüchen genannten Merkmalen.
Figur 1 zeigt ein Ausführungsbeispiel für eine Schaltungsträgeranordnung mit zwei Schaltungsträgern, von denen ein Schaltungsträger wenigstens einen Abstandshalter aufweist, der beim Verlöten der Schaltungsträger mit einem Halbleiterbauelement einen Abstand zwischen den Schaltungsträgern hält, so dass durch eine Längserstreckung des Abstandshalters zwischen den Schaltungsträgern eine Dicke einer Lotschicht bestimmt ist;
Figur 2 zeigt ein Verfahren zum Verbinden eines Abstandshalters mit dem Schaltungsträger;
Figur 3 zeigt einen Verfahrensschritt bei dem Lotpaste auf die Schaltungsträger aufgetragen wird;
Figur 4 zeigt einen Verfahrensschritt, bei dem der Abstandshalter durch einen Durchbruch in dem Schaltungsträger, insbesondere durch den Durchbruch, in dem der Abstandshalter gehalten ist, mittels eines Lasers entfernt wird.

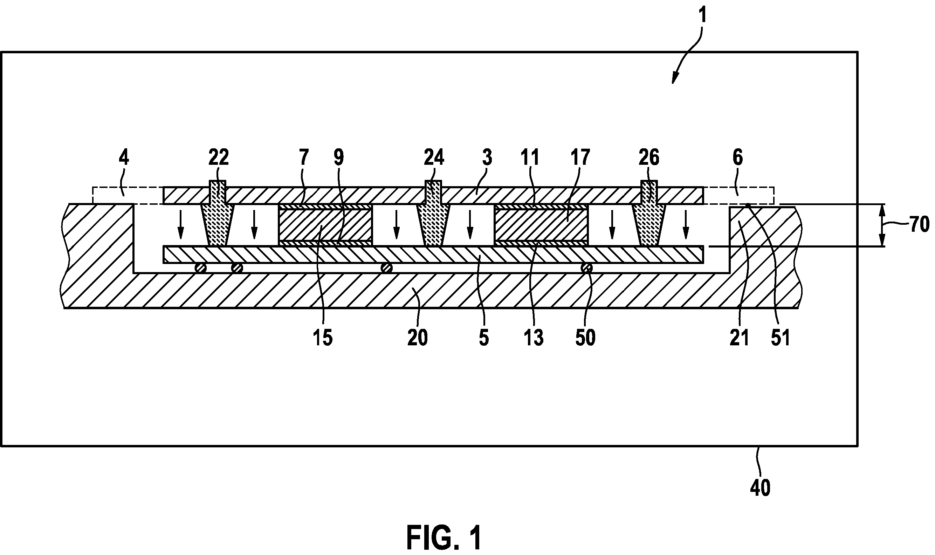

Figur 1 zeigt ein Ausführungsbeispiel für eine Schaltungsträgeranordnung 1. Die Schaltungsträgeranordnung weist einen Schaltungsträger 3 und einen Schaltungsträger 5 auf. Die Schaltungsträger 3 und 5 sind beispielsweise aus gestanztem Kupferblech gebildet und bilden jeweils ein Stanzgitter, auch Lead-Frame genannt. Die Schaltungsträger 3 und 5 erstrecken sich in zueinander parallelen Ebenen und schließen in diesem Ausführungsbeispiel einen Halbleiterschalter 15 und einen Halbleiterschalter 17 zwischeneinander ein.

Die Halbleiterschalter 15 und 17 sind in diesem Ausführungsbeispiel jeweils als gehäuseloser Halbleiterbaustein, auch Bare-Die genannt, ausgebildet. Die Schaltanschlüsse des Halbleiterschalters 15 sind jeweils durch sich zueinander parallel erstreckende Oberflächenbereiche des Halbleiterschalters 15 gebildet. Diese Oberflächenbereiche weisen jeweils eine Metallschicht auf, welche mittels eines Lotes, in diesem Ausführungsbeispiel mittels eines Lotmittels 7 und eines Lotmittels 9 mit dem Schaltungsträger 3 beziehungsweise dem Schaltungsträger 5 verbunden werden können. Der Halbleiterschalter 17 ist mittels des Lotmittels 11 mit dem Schaltungsträger 3 und mittels des Lotmittels 13 mit dem Schaltungsträger 5 verbunden. Die Lotmittel 7, 9, 11 und 13 sind beispielsweise jeweils als Lotpaste ausgebildet, welche auf die Schaltungsträger aufgedruckt werden kann. Der Schaltungsträger 3 weist in diesem Ausführungsbeispiel drei Durchbrüche auf, wobei in einem ersten Durchbruch ein Endabschnitt eines Abstandhalters 22 angeordnet ist, welcher in dem Durchbruch formschlüssig und/oder kraftschlüssig gehalten ist. Erfindungsgemäß ist der Endabschnitt des Abstandhalters zumindest kraftschlüssig in dem Durchbruch gehalten.

Der Schaltungsträger 3 weist auch einen zweiten Durchbruch auf, in welchem ein Abstandshalter 24 mit einem Endabschnitt gehalten ist. Der Schaltungsträger 3 weist auch einen dritten Durchbruch auf, in dem ein Abstandshalter 26 mit einem Endabschnitt gehalten ist.

Die Abstandshalter 22, 24 und 26 sind jeweils zu einem von dem im Schaltungsträger 3 gehaltenen Endabschnitt beabstandeten Ende hin verjüngt ausgebildet. Die Abstandshalter 22, 24 und 26 weisen jeweils im Bereich des in dem Schaltungsträger 3 angeordneten Endabschnittes einen kleineren Durchmesser auf, als in dem sich zu dem verjüngten Ende hin erstreckenden Längsabschnitt, sodass ein Anschlag gebildet ist, welcher beim Einführen des Abstandshalters 22, 24 beziehungsweise 26 in den jeweiligen Durchbruch ein vorbestimmtes Längenmaß des Längenabschnitts bestimmt, welcher sich zwischen dem Schaltungsträger 3 und dem vom Schaltungsträger 3 abweisenden Ende erstreckt.

Während eines Verlötens im Lötofen 40 schmelzen die Lotpasten 7, 9, 11 und 13, sodass der Schaltungsträger 3 zusammen mit den mit dem Schaltungsträger 3 verbundenen Abstandshaltern 22, 24 und 26 schwerkraftgetrieben absinkt und sich auf den Schaltungsträger 5 zubewegt. Dies ist durch Pfeile angedeutet. Die Bewegung des Schaltungsträgers 3 zum Schaltungsträger 5 hin wird durch ein Aufsetzen der Enden der Abstandshalter 22, 24 und 26 auf den Schaltungsträger 5 gestoppt. So kann ein vorbestimmter Abstand 70 zwischen dem Schaltungsträger 3 und dem Schaltungsträger 5 auch während eines Lötens im Lötofen 40 eingehalten werden, sodass die Dicken der Lotpasten 7, 9, 11 und 13 jeweils ein vorbestimmtes Dickenmaß nicht über- oder unterschreiten.

Gestrichelt dargestellt ist auch ein Vorsprungsbereich 4 und ein Vorsprungsbereich 6, welche jeweils an den Abstandshalter 3 angeformt sein können. Diese gestrichelt dargestellten Vorsprungsbereiche 4 und 6 können durch die Abstandshalter 22, 24 und 26 entfallen. Wären nämlich die Abstandshalter 22, 24 und 26 nicht vorhanden, so könnte der Abstand 70 mittels der Vorsprungsbereiche 4 und 6 dadurch eingestellt werden, dass die Vorsprungsbereiche 4 und 6 jeweils auf den Werkstückträger 20, insbesondere Ränder einer Vertiefung in des Werkstückträgers 20 absinken können, in der die Schaltungsträgeranordnung 1 sich beim Löten im Lötofen 40 befindet. Wenn sich beispielsweise zwischen dem Werkstückträger 20, insbesondere an dem Schablonenboden des Werkstückträgers 20 Schmutzpartikel befinden, oder sich zwischen dem gestrichelt dargestellten Vorsprungsbereich 6 und dem Werkstückträgerrand 21 ein Schmutzpartikel 51 befindet, so ergibt sich beim Löten ein anderes Abstandsmaß 70 als ein Abstandsmaß 70 ohne die Schmutzpartikel. Das Schmutzpartikel 50 zwischen dem Schaltungsträger 5 und dem Boden des Werkstückträgers 20 ist beispielhaft bezeichnet. Weitere Einflussfaktoren, welche den Abstand 70 ohne die Abstandshalter 22, 24 und 26 beeinflussen können, sind beispielsweise Dickentoleranzen der Schaltungsträger 3 und 5.

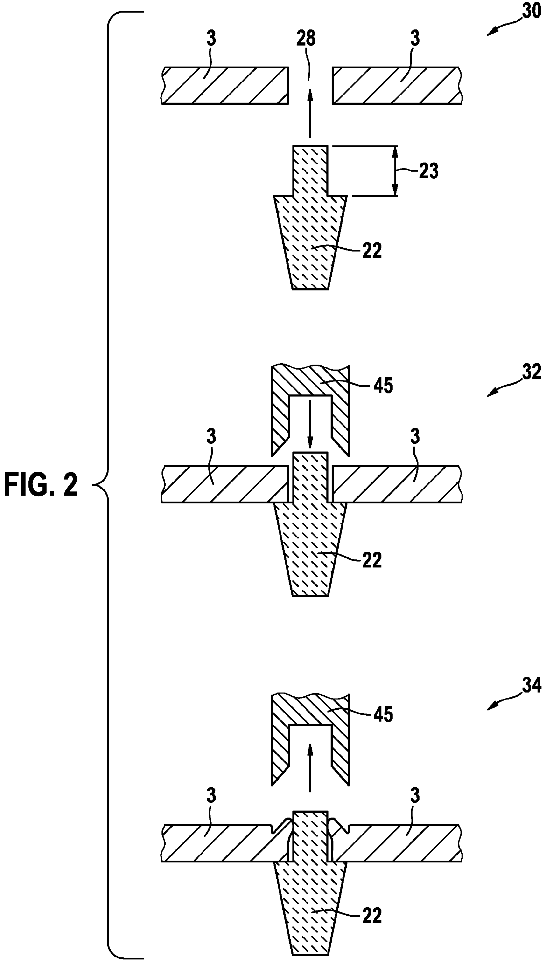

Figur 2 zeigt ein Ausführungsbeispiel für ein erfindungsgemäßes Verfahren zum Zusammenfügen eines Abstandshalters mit einem Schaltungsträger. Dargestellt ist der Schaltungsträger 3, welcher einen Durchbruch 28 aufweist. Dargestellt ist der Abstandshalter 22, welcher mit einem Endabschnitt 23 in den Durchbruch 28 während eines Schritts 30 eingefügt wird. Dies ist durch einen Pfeil angedeutet. In einem Schritt 32 wird dann mittels eines Presswerkzeugs 45 der Schaltungsträger 3, welcher beispielsweise durch ein Kupferblech gebildet ist, im Bereich der Aussparung 28 verpresst. Der Abstandshalter 22 ist während des Verpressens in dem Durchbruch 28 mit dem Endabschnitt 23 angeordnet.

Das Presswerkzeug 45 wird in einem Schritt 34 wieder zurückgefahren. Der Rand des Schaltungsträgers 3 ist im Bereich des Durchbruchs 28 durch das Presswerkzeug 45 radial in den Durchbruch 28 nach innen verpresst worden, sodass der Abstandshalter 22 mit dem Endabschnitt 23 in dem Durchbruch 28 wenigstens kraftschlüssig, oder zusätzlich formschlüssig gehalten ist. Zum Erzielen eines Formschlusses kann der Abstandshalter im Bereich des Endabschnitts 23 eine - in Figur 2 nicht dargestellte - Nut aufweisen.

Der Abstandshalter 22 kann beispielsweise durch einen keramischen Abstandshalter oder einen Kunststoffabstandshalter gebildet sein.

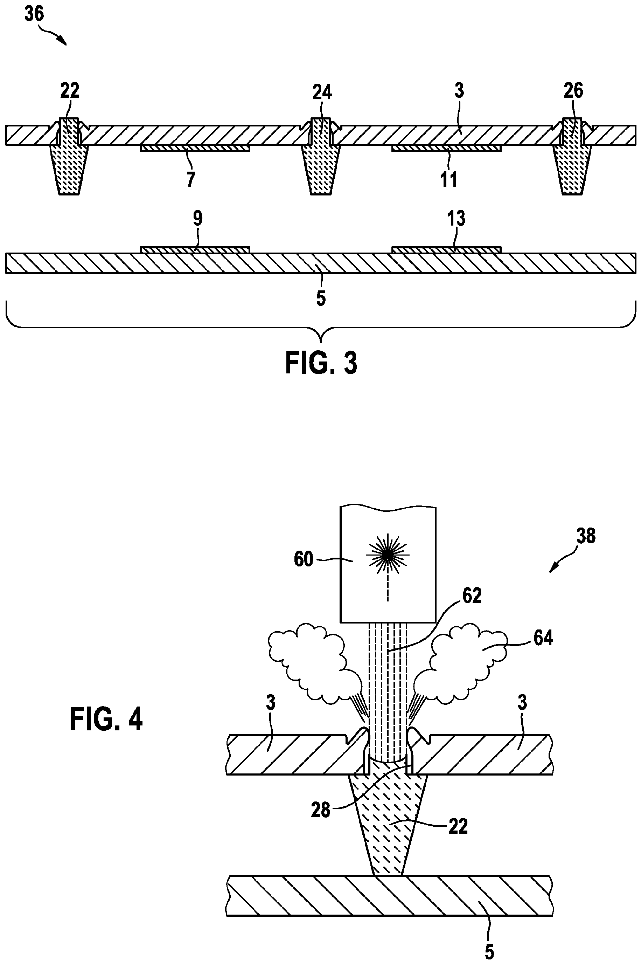

Figur 3 zeigt einen Verfahrensschritt 36, bei dem die Schaltungsträger 3 und 5 jeweils mit Lotpaste zum Verlöten mit den in Figur 1 dargestellten Halbleiterbausteinen 15 und 17 beschichtet werden. Die Halbleiterbausteine 15 und 17 sind in diesem Beispiel jeweils als Halbleiterschalter ausgebildet. Die Lotschichten 7 und 9 kontaktieren jeweils einen Anschluss einer Schaltstrecke des Halbleiterschalters 15. Die Lotschichten 11 und 13 kontaktieren jeweils einen Anschluss einer Schaltstrecke des Halbleiterschalters 17. Die Anschlüsse der Schaltstrecke eines Halbleiterschalters sind jeweils durch zueinander parallel verlaufende Oberflächenbereiche der Halbleiterschalter gebildet. Im Falle eines FeldeffektTransistors als Halbleiterschalter 15 oder 17 ist ein Anschluss der Schaltstrecke ein Source-Anschluss, der andere Anschluss der Schaltstrecke ist ein Drain-Anschluss.

Figur 4 zeigt eine Ausführungsvariante des Verfahrens mit einem Verfahrensschritt 38, der an den in Figur 2 gezeigten Verfahrensschritt 34 anschließen kann. Dargestellt ist ein Laser 60, welcher einen Laserstrahl 62 erzeugt. Mittels des Laserstrahls 62 wird der im Durchbruch 28 des Schaltungsträgers 3 angeordnete Abstandshalter 22 weggebrannt. Dargestellt ist auch Rauch 64, welcher als Verbrennungs- und/oder Verdampfungsprodukt des mittels des Laserstrahls 62 entfernten Abstandshalters 22 entsteht. Die in Figur 1 dargestellten Lötverbindungen, gebildet durch die Lotmittel 7, 9, 11 und 13 können bei zueinander verschiedenen thermischen Ausdehnungen von Komponenten der Schaltungsträgeranordnung, beispielsweise verursacht durch eine Erwärmung der Halbleiterschalter 15 und 17, die Lötverbindungen 7, 9, 11 und 13 nicht mehr mechanisch beanspruchen, da die Abstandshalter im Schritt 38 entfernt wurden.

## Patentansprüche

1. Schaltungsträgeranordnung (1) mit wenigstens einem elektronischen Bauelement (15, 17), wobei die Schaltungsträgeranordnung (1) wenigstens zwei Schaltungsträger (3, 5) aufweist, wobei die Schaltungsträger (3, 5) sich jeweils wenigstens abschnittsweise parallel zueinander erstrecken und das Bauelement (15, 17) wenigstens teilweise zwischeneinander einschließen, wobei das Bauelement (15, 17) mit wenigstens einem Schaltungsträger stoffschlüssig elektrisch leitfähig verbunden ist, wobei die Schaltungsträgeranordnung (1) wenigstens einen elektrisch isolierenden Abstandshalter (22, 24, 26) aufweist, wobei der Abstandshalter (22, 24, 26) mit einem Schaltungsträger (3) verbunden ist, wobei ein Endabschnitt des Abstandshalters in einem Durchbruch des Schaltungsträgers gehalten ist und der Abstandshalter sich quer zum Schaltungsträger (3) bis zu dem anderen Schaltungsträger (5) hin erstreckt, **dadurch gekennzeichnet, dass** der Schaltungsträger (3, 5) im Bereich des Durchbruchs (28) nach Einwirken eines Presswerkzeugs radial in den Durchbruch (28) nach innen verpresst ist (32), so dass der Abstandshalter (22, 24, 26) in dem Durchbruch (28) kraftschlüssig gehalten ist.

2. Schaltungsträgeranordnung (1) nach Anspruch 1, **dadurch gekennzeichnet, dass** das elektronische Bauelement ein Halbleiterbauelement ist.

3. Schaltungsträgeranordnung (1) nach Anspruch 1 oder 2, **dadurch gekennzeichnet, dass** das Bauelement mit wenigstens einem Schaltungsträger mittels Löten elektrisch verbunden ist.

4. Schaltungsträgeranordnung (1) nach einem der vorhergehenden Ansprüchen, **dadurch gekennzeichnet, dass** der Abstandshalter (22, 24, 26) in dem Durchbruch (28) zusätzlich unter Ausbildung eines Formschlusses gehalten ist und dazu im Bereich des Endabschnitts (23) eine Nut aufweist.

5. Schaltungsträgeranordnung (1) nach einem der vorhergehenden Ansprüchen,
**dadurch gekennzeichnet, dass**
der Abstandshalter (22, 24, 26) Kunststoff, insbesondere einen Duroplast aufweist.

6. Schaltungsträgeranordnung (1) nach einem der vorhergehenden Ansprüchen 1-4,
**dadurch gekennzeichnet, dass**
der Abstandshalter (22, 24, 26) aus Keramik oder Glas gebildet ist.

7. Schaltungsträgeranordnung (1) nach Anspruch 5,
**dadurch gekennzeichnet, dass**
der Abstandshalter neben dem Kunststoff einen anorganischen Füllstoff aufweist.

8. Schaltungsträgeranordnung nach Anspruch 7,
**dadurch gekennzeichnet, dass**
der Füllstoff durch Fasern gebildet ist.

9. Schaltungsträgeranordnung nach Anspruch 8,
**dadurch gekennzeichnet, dass**
die Fasern Carbonfasern sind.

10. Schaltungsträgeranordnung nach Anspruch 8,
**dadurch gekennzeichnet, dass**
die Fasern Glasfasern sind.

11. Schaltungsträgeranordnung nach Anspruch 7,
**dadurch gekennzeichnet, dass**
der Füllstoff durch Füllpartikel in Form von Kugeln gebildet ist.

12. Verfahren zum elektrischen Verbinden wenigstens eines elektronischen Bauelementsmit wenigstens zwei Schaltungsträgern (3, 5),
bei dem zwei Schaltungsträger (3, 5) jeweils über ein Lotmittel (7, 9, 11, 13) mit dem Bauelement (15, 17) in berührenden Kontakt gebracht werden, so dass die Schaltungsträger (3, 5) das Bauelement (15, 17) zwischeneinander einschließen, wobei zwischen den Schaltungsträgern wenigstens ein mit einem Schaltungsträger (3, 5) verbundener elektrisch isolierende Abstandhalter (22, 24, 26) angeordnet ist, welcher sich quer zum Schaltungsträger (3) bis zu dem anderen Schaltungsträger (5) hin erstreckt, wobei der wenigstens ein Abstandshalter (22, 24, 26) mit einem Endabschnitt (23) in einen Durchbruch (28) des Schaltungsträgers (3, 5) eingefügt wird und der Schaltungsträger (3, 5) im Bereich des Durchbruchs (28) mittels eines Presswerkzeugs radial in den Durchbruch (28) nach innen
verpresst wird (32), so dass der Abstandshalter (22, 24, 26) in dem Durchbruch (28) kraftschlüssig gehalten ist, wobei bei einem anschließenden Verlöten der Schaltungsträger (3, 5) mit dem Halbleiterbauelement (15, 17) in einem Lötofen (40) beim Schmelzen des Lotmittels (7, 9, 11, 13) die Schaltungsträger (3, 5) aufeinander zu bewegt werden, bis der Abstandshalter (22, 24, 26) zwischen den Schaltungsträgern das Bewegen stoppt, so dass das Lotmittel zwischen dem Halbleiterbauelement und dem Schaltungsträger eine vorbestimmte Dicke aufweist.

13. Verfahren nach Anspruch 12,
**dadurch gekennzeichnet, dass**
das elektronische Bauelement ein Halbleiterbauelement ist.

14. Verfahren nach Anspruch 12 oder 13,
**dadurch gekennzeichnet, dass**
die Schaltungsträger (3, 5) mittels Schwerkraft aufeinander zu bewegt werden.

## Claims

1. Circuit carrier assembly (1) with at least one electronic component (15, 17), wherein the circuit carrier assembly (1) has at least two circuit carriers (3, 5), wherein the circuit carriers (3, 5) extend in each case parallel to one another, at least in certain portions, and at least partially enclose the component (15, 17) between them, wherein the component (15, 17) is electrically conductively connected in a material-bonding manner to at least one circuit carrier, wherein the circuit carrier assembly (1) has at least one electrically insulating spacer (22, 24, 26), wherein the spacer (22, 24, 26) is connected to a circuit carrier (3), wherein an end portion of the spacer is held in an opening in the circuit carrier and the spacer extends transversely in relation to the circuit carrier (3) up to the other circuit carrier (5), **characterized in that**, after being acted on by a pressing tool, the circuit carrier (3, 5) in the region of the opening (28) is pressed radially inwards (32) into the opening (28), so that the spacer (22, 24, 26) is held in a force-fitting manner in the opening (28).

2. Circuit carrier assembly (1) according to Claim 1, **characterized in that** the electronic component is a semiconductor component.

3. Circuit carrier assembly (1) according to Claim 1 or 2, **characterized in that** the component is electrically connected to at least one circuit carrier by means of soldering.

4. Circuit carrier assembly (1) according to one of the preceding claims, **characterized in that** the spacer (22, 24, 26) is additionally held in the opening (28) by the forming of a form fit and for this purpose has a groove in the region of the end portion (23).

5. Circuit carrier assembly (1) according to one of the preceding claims, **characterized in that** the spacer (22, 24, 26) comprises plastic, in particular a thermosetting plastic.

6. Circuit carrier assembly (1) according to one of the preceding Claims 1-4, **characterized in that** the spacer (22, 24, 26) is formed from ceramic or glass.

7. Circuit carrier assembly (1) according to Claim 5, **characterized in that** the spacer comprises in addition to the plastic an inorganic filler.

8. Circuit carrier assembly according to Claim 7, **characterized in that** the filler is formed by fibres.

9. Circuit carrier assembly according to Claim 8, **characterized in that** the fibres are carbon fibres.

10. Circuit carrier assembly according to Claim 8, **characterized in that** the fibres are glass fibres.

11. Circuit carrier assembly according to Claim 7, **characterized in that** the filler is formed by filling particles in the form of beads.

12. Method for electrically connecting at least one electronic component to at least two circuit carriers (3, 5), in which two circuit carriers (3, 5) are in each case brought into touching contact with the component (15, 17) by means of a solder (7, 9, 11, 13), so that the circuit carriers (3, 5) enclose the component (15, 17) in them, wherein there is arranged between the circuit carriers at least one electrically insulating spacer (22, 24, 26), which is connected to a circuit carrier (3, 5) and extends transversely in relation to the circuit carrier (3) up to the other circuit carrier (5), wherein the at least one spacer (22, 24, 26) is inserted by an end portion (23) into an opening (28) in the circuit carrier (3, 5) and the circuit carrier (3, 5) in the region of the opening (28) is pressed radially inwards (32) by means of a pressing tool into the opening (28), so that the spacer (22, 24, 26) is held in a force-fitting manner in the opening (28), wherein, during a subsequent soldering of the circuit carriers (3, 5) to the semiconductor component (15, 17) in a soldering furnace (40), as the solder (7, 9, 11, 13) is melting, the circuit carriers (3, 5) are moved towards one another until the spacer (22, 24, 26) between the circuit carriers stops the movement, so that the solder between the semiconductor component and the circuit carrier has a predetermined thickness.

13. Method according to Claim 12, **characterized in that** the electronic component is a semiconductor component.

14. Method according to Claim 12 or 13, **characterized in that** the circuit carriers (3, 5) are moved towards one another by means of gravitational force.

## Revendications

1. Agencement de supports de circuits (1) muni d'au moins un composant électronique (15, 17), l'agencement de supports de circuits (1) comprenant au moins deux supports de circuits (3, 5), les supports de circuits (3, 5) s'étendant chacun au moins en sections parallèlement les uns aux autres et le composant (15, 17) étant inclus au moins partiellement entre eux, le composant (15, 17) étant relié de manière électriquement conductrice par accouplement de matière avec au moins un support de circuits,
l'agencement de supports de circuits (1) comprenant au moins un espaceur électriquement isolant (22, 24, 26), l'espaceur (22, 24, 26) étant relié avec un support de circuits (3), une section d'extrémité de l'espaceur étant maintenue dans une percée du support de circuits et l'espaceur s'étendant perpendiculairement au support de circuits (3) jusqu'à l'autre support de circuits (5),
**caractérisé en ce que**, dans la zone de la percée (28), le support de circuits (3, 5) est pressé radialement vers l'intérieur (32) dans la percée (28) après l'action d'un outil de pressage, de telle sorte que l'espaceur (22, 24, 26) soit maintenu par accouplement de force dans la percée (28).

2. Agencement de supports de circuits (1) selon la revendication 1, **caractérisé en ce que** le composant électronique est un composant semi-conducteur.

3. Agencement de supports de circuits (1) selon la revendication 1 ou 2, **caractérisé en ce que** le composant est relié électriquement par brasage avec au moins un support de circuits.

4. Agencement de supports de circuits (1) selon l'une quelconque des revendications précédentes, **caractérisé en ce que** l'espaceur (22, 24, 26) est en outre maintenu dans la percée (28) avec formation d'un accouplement de forme et comprend pour cela une rainure dans la zone de la section d'extrémité (23).

5. Agencement de supports de circuits (1) selon l'une quelconque des revendications précédentes, **caractérisé en ce que** l'espaceur (22, 24, 26) comprend de la matière plastique, notamment un thermodurcissable.

6. Agencement de supports de circuits (1) selon l'une quelconque des revendications 1 à 4 précédentes, **caractérisé en ce que** l'espaceur (22, 24, 26) est formé en céramique ou en verre.

7. Agencement de supports de circuits (1) selon la revendication 5, **caractérisé en ce que** l'espaceur comprend une charge inorganique en sus de la matière plastique.

8. Agencement de supports de circuits selon la revendication 7, **caractérisé en ce que** la charge est formée par des fibres.

9. Agencement de supports de circuits selon la revendication 8, **caractérisé en ce que** les fibres sont des fibres de carbone.

10. Agencement de supports de circuits selon la revendication 8, **caractérisé en ce que** les fibres sont des fibres de verre.

11. Agencement de supports de circuits selon la revendication 7, **caractérisé en ce que** la charge est formée par des particules de charge sous la forme de billes.

12. Procédé de liaison électrique d'au moins un composant électronique avec au moins deux supports de circuits (3, 5), selon lequel deux supports de circuits (3, 5) sont chacun mis en contact contigu avec le composant (15, 17) par l'intermédiaire d'un moyen de brasage (7, 9, 11, 13), de telle sorte que les supports de circuits (3, 5) incluent le composant (15, 17) entre eux, au moins un espaceur électriquement isolant (22, 24, 26) relié avec un support de circuits (3, 5) étant agencé entre les supports de circuits, qui s'étend perpendiculairement au support de circuits (3) jusqu'à l'autre support de circuits (5), l'au moins un espaceur (22, 24, 26) étant inséré avec une section d'extrémité (23) dans une percée (28) du support de circuits (3, 5) et, dans la zone de la percée (28), le support de circuits (3, 5) étant pressé radialement vers l'intérieur (32) dans la percée (28) au moyen d'un outil de pressage, de telle sorte que l'espaceur (22, 24, 26) soit maintenu par accouplement de force dans la percée (28) ; lors d'un brasage ultérieur des supports de circuits (3, 5) avec le composant semi-conducteur (15, 17) dans un four de brasage (40), lors de la fusion du moyen de brasage (7, 9, 11, 13), les supports de circuits (3, 5) étant déplacés l'un sur l'autre jusqu'à ce que l'espaceur (22, 24, 26) entre les supports de circuits stoppe le déplacement, de telle sorte que le moyen de brasage entre le composant semi-conducteur et le support de circuits présente une épaisseur prédéterminée.

13. Procédé selon la revendication 12, **caractérisé en ce que** le composant électronique est un composant semi-conducteur.

14. Procédé selon la revendication 12 ou 13, **caractérisé en ce que** les supports de circuits (3, 5) sont déplacés l'un sur l'autre au moyen de la force de pesanteur.
